# EUROPEAN PATENT SPECIFICATION

(11) **EP 0 715 328 B1**
(45) Date of publication and mention of the grant of the patent: **09.05.2001**
(21) Application number: 95116505.9
(22) Date of filing: 19.10.1995
(51) Int. Cl.: H01H 85/048, H01H 85/046

(54) **Protective device**
Schutzeinrichtung
Dispositif de protection

(30) Priority: 30.11.1994 JP 32355994
(43) Date of publication of application: 05.06.1996
(73) Proprietor: Sony Chemicals Corporation, Tokyo 103-0022 (JP)
(72) Inventor: Takeichi, Motohide, Kanuma-shi, Tochigi 322 (JP); Iwasaki, Norikazu, Kanuma-shi, Tochigi 322 (JP); Furuuchi, Yuji, Kanuma-shi, Tochigi 322 (JP)
(74) Representative: Leson, Thomas Johannes Alois, Dipl.-Ing.

(56) References cited:
- EP-A- 0 078 165
- EP-A- 0 096 834
- WO-A-95/23423

## Description

This invention relates to a protective device making use of a low-melting metal piece such as a fuse. More particularly, this invention relates to a protective device useful for preventing an overvoltage, a voltage exceeding the rated operating voltage.

As protective devices making use of a low-melting metal piece made of lead, tin, antimony or the like, electric current fuses which blow upon flow of an overcurrent to break the current have been hitherto widely used. Such fuses are known to have various forms, including a link fuse, which is formed of a flat rectangular low-melting metal piece provided with fastenings at its both ends; a cartridge fuse, which is formed of a rod-like low-melting metal piece enclosed in a glass tube; and a chip type fuse, which is formed of a rectangular solid form low-melting metal piece provided with a lead terminal. Besides these, temperature fuses which blow at temperatures exceeding given temperatures are also used as protective devices.

All types of the conventional protective devices, however, have the problem that they can be mounted on wiring substrates with difficulty. As a countermeasure therefor, a chip type fuse is proposed in which a fuse is buried and enclosed in a resin of a rectangular solid form and a lead terminal of the fuse is formed on the surface of the resin of a rectangular solid form (JP-A-4-192237). However, if the fuse is merely buried and enclosed in resin, the fuse may melt when an overcurrent flows, but does not necessarily blow. Thus, there is the problem that such a fuse can not afford to stably function as a protective device.

As to the size of commercially available chip type fuses, they are approximately 2.6 mm thick × 2.6 mm wide × 6 mm long even for those of a smaller size, and have a size larger than other electronic parts mounted on a substrate. In particular, the thickness of the chip type fuses is as very large as about 2.6 mm, while the thickness of ICs is commonly about 1 mm. Hence, it follows that the height of a substrate after packaging is restricted by the chip type fuse. This hinders the achievement of decrease in packaging space. Accordingly, it has been a subject how the thickness of the chip type fuse also is made as small as about 1 mm.

With recent development of industries, in addition to the conventional electric current fuses and temperature fuses, it has become sought to provide a protective device that acts upon overvoltage.

For example, in lithium ion cells attracting notice as secondary cells with a high energy density, a dendrite is produced on the surface of the electrode as a result of overcharging to greatly damage cell performance, and hence, when cells are charged, it is necessary to prevent them from being charged beyond the rated voltage.
However, no protective devices useful for preventing such overcharging have been hitherto developed. In practice, as a protective mechanism for lithium ion cells, a protective mechanism is provided which is so designed that, when electric currents exceeding the rated value flow through the cell, a PTC (positive temperature coefficient resistor) generates heat and a fuse blows. Such a protective mechanism, however, can not be used to prevent overcharging. Hence, it is sought to provide a new protective device for preventing overcharging. In particular, as a protective device used when cells are thus charged, it is sought to provide a device free of danger such as ignition and having a high safety when used.

From EP-A-0096834 a fuse element not being covered by a protection layer and a temperature resistor are known which are thermally coupled. The temperature resistor has the function of detecting the temperature of the fuse element and of interrupting the fuse circuit or effecting another protective measure in case the temperature of the fuse exceeds a predetermined value and the fuse is not molten yet.

Further, EP-A-0078165 discloses a programmable fuse device comprising a silicon substrate, a first wiring layer provided on the substrate and made of polycrystalline silicon or a metal having a high melting point, an insulating layer covering the surface of the first wiring layer, and a second wiring layer crossing the insulating layer and consisting of aluminium. The first wiring layer serves as a heater capable of generating heat for melting crossing portions of the second wiring layer. For ensuring a higher reliability of the programmable fuse device, the second layer is covered by a passivation or protecting layer being made of phosphorous glass.

The object of the invention is to provide a protective device adapted for use in an overvoltage protector and being small in size and stable in operation and an overvoltage protector using this protective device.

The above object is achieved by providing a protective device according to claim 1 or claim 2 and an overvoltage protector according to claim 6.

The effects and advantages of the protective device and the overvoltage protector of the invention as well as of the further developments defined in the subclaims will become apparent from the following description of the preferred embodiments with reference to the accompanying drawings.

Figs. 1A and 1B are a plan view and an X-X cross section, respectively, of a basic part of a protective device of the present invention.

Figs. 2A and 2B are a plan view and an X-X cross section, respectively, of a protective device according to an embodiment of the present invention.

Figs. 3A and 3B are a plan view and an X-X cross section, respectively, of a protective device according to another embodiment of the present invention.

Fig. 4 is a circuit diagram of an overvoltage protector making use of the protective device of the present invention.

Figs. 5A and 5B are a plan view and an X-X cross section, respectively, of a protective device according to still another embodiment of the present invention.

Fig. 6 is a circuit diagram of an overvoltage protector according to another embodiment, making use of the protective device of the present invention.

Fig. 7 is a graph to show changes with time in electric currents when a voltage is applied to a heating element of the protective device according to Examples.

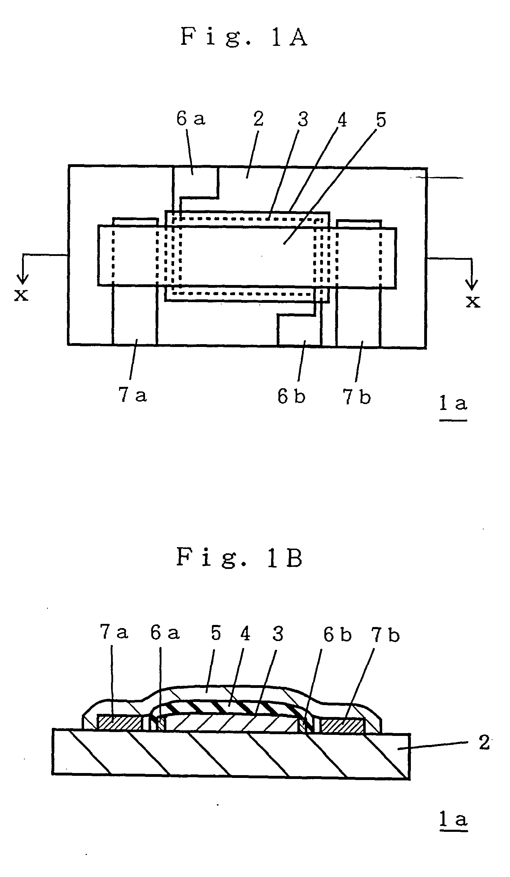

Figs. 1A and 1B illustrate a basic part of the protective device according to the invention. As shown in Fig. 1A, a plan view, and Fig. 1B, an X-X cross section, this basic part of the protective device, denoted as la, comprises a substrate 2, a heating element 3 provided on the substrate, an insulating layer 4 that covers the surface of the heating element 3, and a low-melting metal piece 5 provided on the insulating layer 4. Here, the heating element 3 and the low-melting metal piece 5 are connected to heating element terminals 6a and 6b and low-melting metal piece terminals 7a and 7b, respectively.

In the present invention, as the substrate 2 of such a protective device, a substrate of an inorganic type such as a ceramic substrate or a metal substrate is used. There are no particular limitations on the thickness of the substrate 2. From the viewpoint of making the protective device small in size, the substrate may preferably be in a thickness of approximately from 0.1 mm to 1.0 mm in usual instances.

The heating element 3 has a useful function that it serves as a heat source for causing the low-melting metal piece to blow when, as will be described later, the protective device is used in combination with a voltage detecting means such as a zener diode so that it can function as an overvoltage-preventive protective device. In the present invention, a heating element formed of an inorganic material is used as the heating element 3. For example, a heating element comprising a conductive material such as ruthenium oxide or carbon black and an inorganic binder such as water glass may be used. As materials for such a heating element, commercially available inorganic resistive pastes may be used. The heating element 3 formed of an inorganic material can be readily formed by coating such an inorganic resistive paste on the substrate, followed by baking. Even when an organic component is contained in the resistive paste, the organic component is decomposed and removed in the course of baking. Hence, the resistive paste to be coated on the substrate may contain an organic component.

Thus, the use of the heating element 3 formed of not an organic material but an inorganic material makes it possible to greatly control the effects of heat upon the resistance of the heating element 3. Hence, even when the heating element 3 is kept electrically excited for a long time during the use of the protective device and the heating element 3 continues to generate heat, the state of such heat generation can be stable and no runaway may occur. Accordingly, it becomes possible to obtain a protective device having no danger of ignition due to excessive heat generation and having a superior safety. Also, the use of an inorganic substrate as the substrate 2 makes it possible to readily form the heating element 3 formed of an inorganic material, by coating a resistive paste on the substrate followed by baking. Since also the substrate itself can be inflammable, the safety in use of the protective device can be increased.

The insulating layer 4 is a layer that insulates the heating element 3 from the low-melting metal piece 5. There are no particular limitations on materials for this insulating layer 4. For example, it is possible to use various organic resins such as epoxy resins, acrylic resins and polyester resins, or inorganic materials mainly composed of SiO₂. When an organic resin is used in the insulating layer 4, an inorganic powder with a high thermal conductivity may be dispersed therein. This enables effective conduction of the heat of the heating element 3 at the time of its heat generation, to the low-melting metal piece 5. Such an inorganic powder is exemplified by boron nitride (thermal conductivity: 0.18 cal/cm·sec·°C) and alumina (thermal conductivity: 0.08 cal/cm·sec·°C), any of which may be used.

The low-melting metal piece 5 may be formed of any of various low-melting metals conventionally used for fuse materials. For example, it may be formed of any of alloys shown in Table 1.

**Table 1**

| Alloy composition | Liquid-phase point (°C) |
|---|---|
| Bi:Sn:Pb = 52.5:32.0:15.5 | 95 |
| Bi:Pb:Sn = 55.5:44.0:1.0 | 120 |
| Pb:Bi:Sn = 43.0:28.5:28.5 | 137 |
| Bi:Pb = 55.5:44.5 | 124 |
| Bi:Sn = 58.0:42.0 | 138 |
| Sn:Pb = 63.0:37.0 | 183 |
| Sn:Ag = 97.5:2.5 | 226 |
| Sn:Ag = 96.5:3.5 | 221 |
| Pb:In = 81.0:19.0 | 280 |
| Zn:Al = 95.0:5.0 | 282 |
| In:Sn = 52.0:48.0 | 118 |
| Pb:Ag:Sn = 97.5:1.5:1.0 | 309 |

The heating element terminals 6a and 6b and the low-melting metal piece terminals 7a and 7b can be formed in the same manner as electrode terminals usually formed on the substrate. For example, they may be formed by patterning of copper foil, by nickel plating and gold plating successively applied on a copper pattern, or by soldering on a copper pattern.

The basic part of the protective device 1a as shown in Fig. 1 is produced by, for example, a process comprising forming terminals 6a, 6b, 7a and 7b on the inorganic substrate 2 by a conventional method, subsequently coating an inorganic resistive paste by screen printing or the like, followed by baking to form the heating element 3, coating an insulating resin on the surface of the heating element 3 by printing or the like, followed by curing to form the insulating layer, and further bonding a low-melting metal foil onto the insulating layer 4 by hot pressing to provide the low-melting metal piece 5.

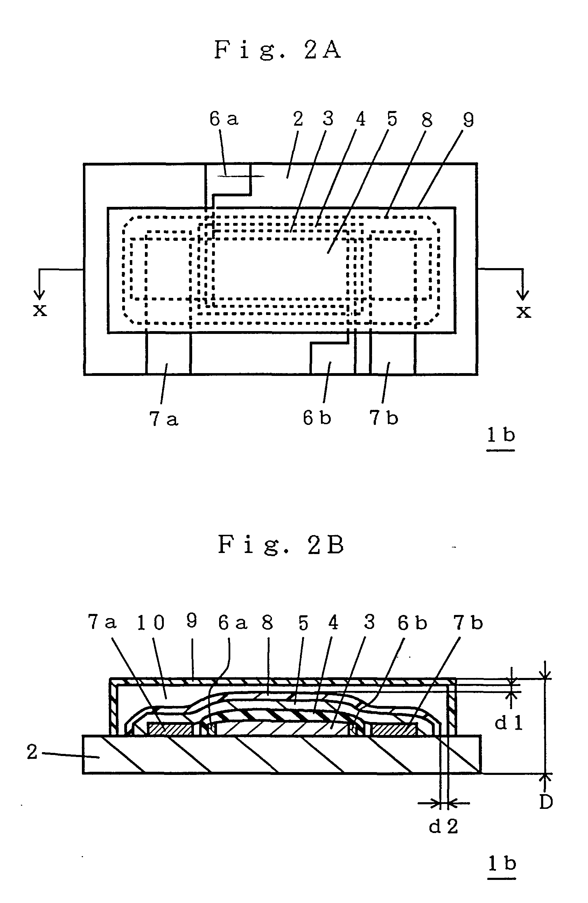

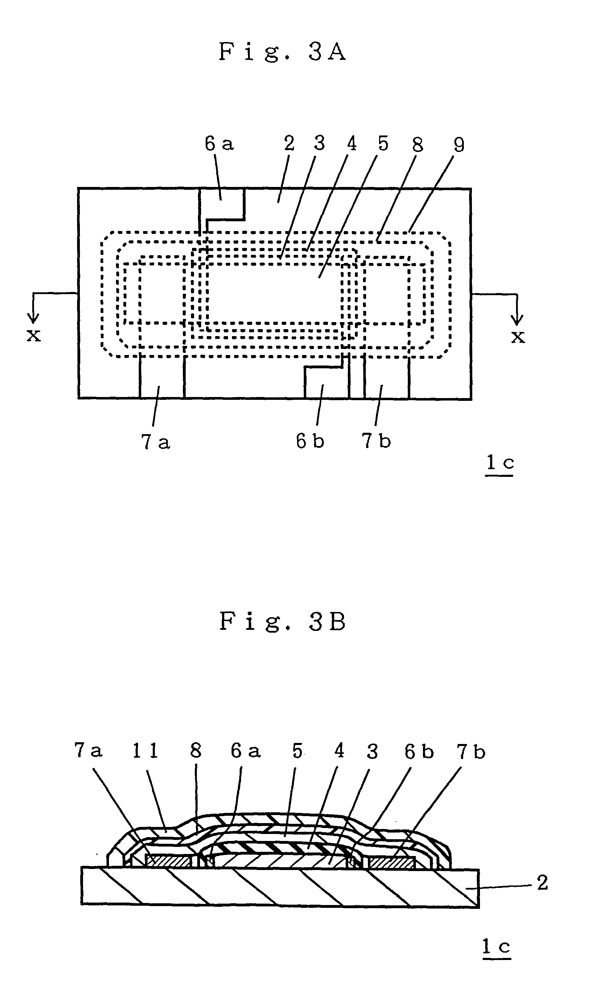

As stated above, the protective device of the present invention is constituted of the basic part comprising the heating element 3 formed of an inorganic material, provided on the inorganic substrate 2, the insulating layer 4 and the low-melting metal piece 5. Additionally, as shown in Figs. 2A and 2B or Figs. 3A and 3B, the low-melting metal piece 5 is sealed with an inner sealing portion 8 and its outer surface is further covered with an outside casing or an outer sealing portion.

More specifically, Figs. 2A and 2B are a plan view (Fig. 2A) and an X-X cross section (Fig. 2B), of a protective device 1b in which the low-melting metal piece 5 of the basic part of the protective device 1a in Fig. 1 as described above is sealed with an inner sealing portion 8 which is formed of a material having a lower melting point or lower softening point than the low-melting metal piece 5 and its outer surface is further covered with an outside casing 9.

Once the surface of the low-melting metal piece 5 is oxidized, the oxidized surface thereof does not melt even when the low-melting metal piece 5 is heated to its inherent melting temperature, so that the low-melting metal piece 5 does not blow in some occasions. However, the sealing of the low-melting metal piece 5 with the inner sealing portion 8 can prevent the low-melting metal piece 5 from its surface oxidation, and hence makes it possible to surely cause the low-melting metal piece to blow when it is heated to a given temperature. Since also the inner sealing portion 8 is formed of a material having a lower melting point or lower softening point than the low-melting metal piece 5, the sealing of the low-melting metal piece 5 with this inner sealing portion 8 by no means hinders the low-melting metal piece 5 from blowing.

The inner sealing portion 8 may preferably be made to act not only to prevent the surface oxidation of the low-melting metal piece 5 but also to remove any metal oxide film formed on the surface. Hence, as sealing compounds used in the inner sealing portion 8, it is preferable to use sealing compounds capable of removing metal oxide films, as exemplified by organic acids and inorganic acids. In particular, a non-corrosive solid flux containing abietic acid as a main component is preferred. This is because the abietic acid is solid and inactive at room temperature, but melts upon heating to about 120°C or above and turn active to exhibit the action to remove metal oxides, and hence it is possible not only to surely cause the low-melting metal piece to blow when it is heated to a given temperature but also to improve the storage stability of the protective device. As a method to form the inner sealing portion 8 by the use of the solid flux, it is preferable to melt the solid flux by heating without use of a solvent from the viewpoint of preventing craters, and coating the resulting molten product on the low-melting metal piece 5.

The inner sealing portion 8 may preferably have a thickness, depending on the type of the sealing compound, of approximately from 10 to 100 *µ*m in usual instances, from the viewpoint of preventing surface oxidation of the low-melting metal piece 5 or from the viewpoint of the ability to remove surface oxide films.

The outside casing 9 is provided so that any molten product can be prevented from flowing out of the protective device when the low-melting metal piece 5 or inner sealing portion 8 melts. It is preferable for this outside casing 9 to be so provided as to leave a gap 10 between it and the inner sealing portion 8 as shown in Fig. 2B. In this instance, a size d1 of the gap in the vertical direction may preferably be set at approximately from 50 to 500 *µ*m, and a size d2 in the horizontal direction, approximately from 0.2 to 1.0 mm. The gap 10 with such size assures the space in which the molten product can move when the low-melting metal piece 5 or inner sealing portion 8 melts, and hence makes it possible to surely cause the low-melting metal piece 5 to blow.

There are no particular limitations on materials for constituting the outside casing 9. From the viewpoint of taking the form of a housing having the space defined over the inner sealing portion 8 and from the viewpoint of thermal resistance and flame retardance, it is preferable to use nylon 4/6, liquid-crystal polymer or the like to which a flame-retardant has been added.

When the low-melting metal piece 5 is sealed with the inner sealing portion 8 and also the inner sealing portion 8 is covered with the outside casing 9 so as to leave the gap 10 between them, it is possible to ensure the reliability for the low-melting metal piece 5 to blow when heated to a given temperature and also to make the protective device have as a whole a thickness D of about 1 mm or less. Thus, such a protective device 1b can be a protective device good enough to meet the demand for making the protective device reliable in operation and smaller in size.

Meanwhile, Figs. 3A and 3B are a plan view (Fig. 3A) and an X-X cross section (Fig. 3B), of a protective device 1c in which the outside casing 9 that covers the inner sealing portion 8 in the above protective device 1b shown in Figs. 2A and 2B is replaced with an outer sealing portion 11 with which the inner sealing portion 8 is sealed. This outer sealing portion 11 is also provided so that any molten product can be prevented from flowing out of the protective device when the low-melting metal piece 5 or inner sealing portion 8 melts. Accordingly, as constituent materials therefor, those having a higher melting point or higher softening point than the low-melting metal piece 5 are used. For example, epoxy type sealing compounds or phenol type sealing compounds may be used.

In the protective device 1b previously shown in Figs. 2A and 2B, it is enough for the inner sealing portion 8 to have a thickness of approximately from 10 to 100 *µ*m in usual instances, from the viewpoint of preventing surface oxidation of the low-melting metal piece 5 or from the viewpoint of the ability to remove surface oxide films. In the case of the protective device 1c shown in Figs. 3A and 3B, it becomes possible for the low-melting metal piece 5 to blow on account of the melt flow within the region where the inner sealing portion 8 is formed. Accordingly, the inner sealing portion 8 may preferably have a thickness of approximately from 500 to 1,500 *µ*m from the viewpoint of causing the low-melting metal piece 5 to surely blow.

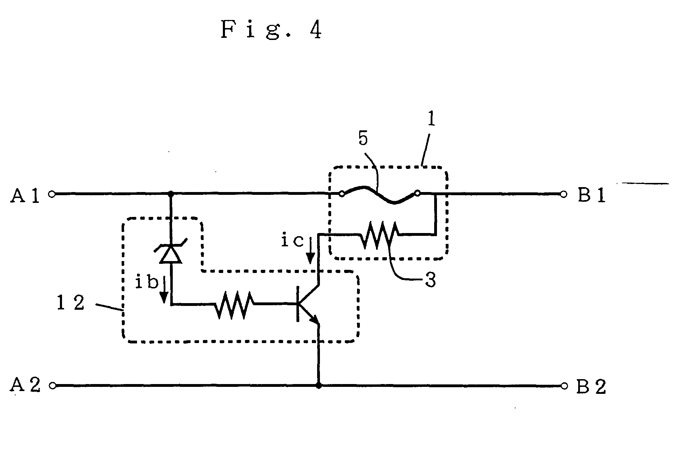

The protective devices 1 (1b and 1c) shown in Figs. 2A and 2B to Figs. 3A and 3B can each be used in combination with a voltage detecting means 12 comprised of a zener diode and a transistor, to set up a overvoltage protector as shown by a circuit diagram in Fig. 4. In the circuit shown in Fig. 4, terminals A1 and A2 are connected with electrode terminals of a unit to be protected, e.g., a lithium ion cell, and terminals B1 and B2 are connected with electrode terminals of a unit such as a charger which, when used, is connected with the unit to be protected. According to this circuit construction, a base current ib abruptly flows when the charging of the lithium ion cell proceeds until a reverse voltage exceeding the breakdown voltage is applied to the zener diode of the voltage detecting means 12, whereupon a great collector current ic flows through the heating element 3 to electrically excite it, and the heating element 3 generates heat to cause the low-melting metal piece 5 on the heating element to blow, so that the overvoltage can be prevented from being applied across the terminals A1 and A2. Thus, the present invention also embraces an overvoltage protector comprising the above protective device 1 of the present invention and the voltage detecting means 12; the heating element of the protective device being electrically excited through the voltage detecting means to generate heat.

In the foregoing, the protective device and overvoltage protector of the present invention have been described in detail. Besides the above embodiments, the protective device and overvoltage protector of the present invention may have other various embodiments.

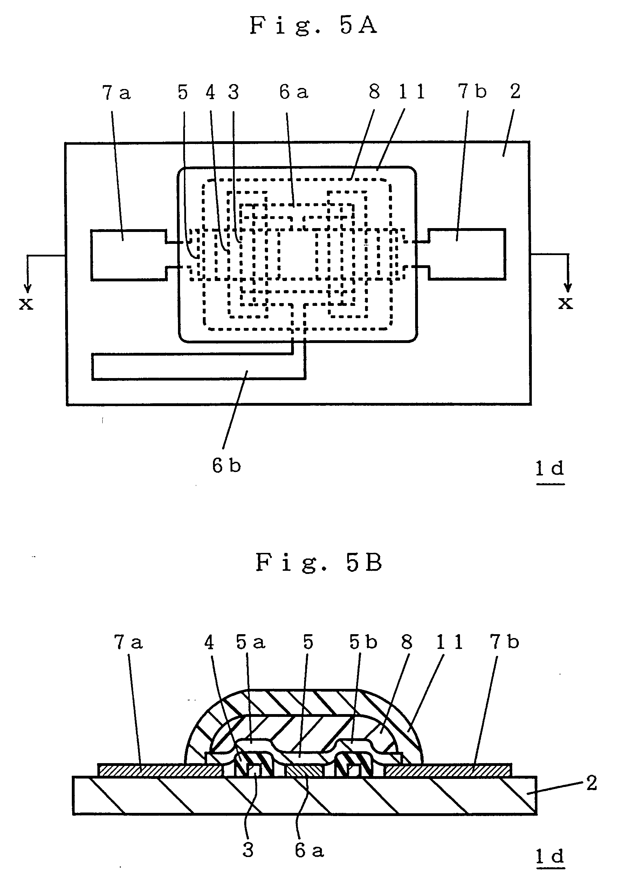

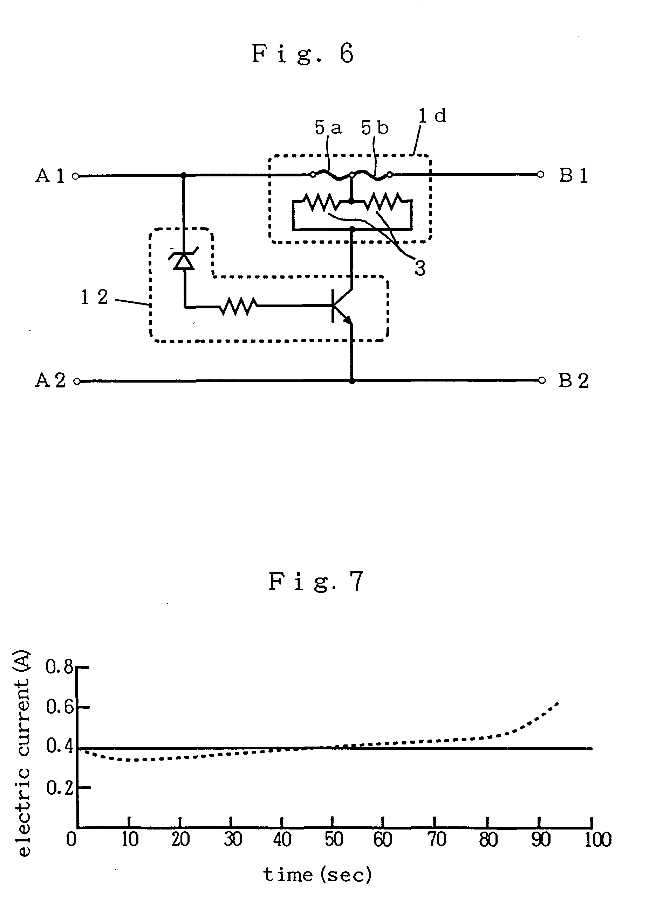

For example, Figs. 5A and 5B are a plan view (Fig. 5A) and an X-X cross section (Fig. 5B), of a protective device 1d in which the planar patterns of the heating element 3 and low-melting metal piece 5 of the protective device shown in Fig. 1 were so changed that the low-melting metal piece 5 may blow at two points 5a and 5b upon heating. Fig. 6 is a circuit diagram of an overvoltage protector constituted using the protective device 1d.

In the circuit construction shown in Fig. 4 as previous described, where the terminals A1 and A2 are connected with electrode terminals of a lithium ion cell and the terminals B1 and B2 are connected with electrode terminals of a charger, the heating element 3 is still kept electrically excited even after the low-melting metal piece 5 of the protective device 1 has blown because of overcharging. In contrast, according to the circuit construction shown in Fig. 6, the heating element 3 is completely stopped from electrical excitation after the low-melting metal piece 5 has blown at the two points 5a and 5b. Thus, it becomes possible to more improve the safety required for overvoltage protectors.

As described above, the protective device of the present invention comprises an inorganic substrate, a heating element formed of an inorganic material, provided on the substrate, an insulating layer that covers the surface of the heating element, and a low-melting metal piece provided on the insulating layer. Thus, the use of this protective device in combination with a voltage detecting means makes it possible to set up a overvoltage protector. More specifically, upon detection of an overvoltage by the voltage detecting means, the heating element of the protective device generates heat to cause the low-melting metal piece provided thereon, to blow.

Here, since the heating element of the protective device is formed of an inorganic material, the resistance of the heating element can be stable even when the heat generation continues. Hence, even when the heating element 3 is kept electrically excited for a long time during the use of the protective device and the heating element 3 continues to generate heat, the state of such heat generation can be stable and no runaway may occur.

### EXAMPLES

### Example 1

For evaluation a basic part of a protective device (with an inorganic type heating element), like the one shown in Figs. 1A and 1B, was produced in the following way.

First, as an inorganic substrate, an alumina-based ceramic (thickness: 0.5 mm) was prepared, and a silver paste (QS174, available from Du Pont de Nemours, E.I., Co.) was coated by screen printing in a terminal pattern as shown in Fig. 1, followed by baking at 870°C for 30 minutes to form heating element terminals 6a and 6b and low-melting metal piece terminals 7a and 7b. Next, between the heating element terminals 6a and 6b, a ruthenium oxide resistive paste (DP1900, available from Du Pont de Nemours, E.I., Co.) was coated by screen printing, followed by baking at 870°C for 30 minutes to form a heating element 3 with a resistance of 10 Ω. Then, a silica resistive paste (AP5346, available from Du Pont de Nemours, E.I., Co.) was printed on the heating element so as not to cover the low-melting metal piece terminals 7a and 7b, followed by baking at 500°C for 30 minutes to form an insulating layer 4. Next, onto the heating element terminals 6a and 6b, a low-melting metal foil (Sn:Sb = 95:5; liquid-phase point: 240°C) of 1 mm × 4 mm was bonded by hot pressing to form a low-melting metal piece 5. Thus, the basic part of a protective device (with an inorganic type heating element) of the present invention was produced.

### Comparative Example 1

The procedure of Example 1 was repeated to produce a basic part of a protective device comprising an organic type heating element, except that the heating element 3 was formed using a phenol type carbon paste (FC-403R, available from Fujikura Kasei Co., Ltd.) and the insulating layer 4 was formed using an epoxy resistive paste.

### - Evaluation -

To test each of the basic parts of the protective devices of Example 1 and Comparative Example 1, a voltage of 4 V was applied across the heating element terminals 6a and 6b, where changes with time in electric currents and the time by which the low-melting metal piece 5 blew were measured and also how it blew was visually observed.

The changes with time in electric currents, thus measured, are shown in Fig. 7. As is seen from Fig. 7, the heating element of Example 1, as indicated by a solid line in Fig. 7, shows always stable electric current values, and proves to cause no change in its resistance. On the other hand, the heating element of Comparative Example 1, as indicated by a dotted line in Fig. 7, shows an increase in electric current values which begins in about 15 seconds after start of electrical excitation, and proves to have caused a decrease in resistance. As is also seen therefrom, the heating element of Comparative Example 1 shows an abrupt increase in electric current values in about 80 seconds after start of electrical excitation.

In the basic part of the protective device of Example 1, the time by which the low-melting metal piece 5 blew was 21 seconds, and no particular changes were seen throughout in appearance of the heating element. On the other hand, in the basic part of the protective device of Comparative Example 1, the time by which the low-melting metal piece 5 blew was 19 seconds, and the heating element caught fire in about 93 seconds after start of electrical excitation.

From the above results, it has been confirmed that a protective device promising a higher safety can be obtained when the heating element is formed of the inorganic material.

### Example 2

To produce a protective device according to the embodiment as shown in Figs. 2A and 2B, the procedure in Example 1 was followed except that on the low-melting metal piece 5 of the protective device a pasty flux (HA 78 TS-M, available from Tarutin Co., Ltd.) was coated in a thickness of about 0.5 mm to form an inner sealing portion 8 and then an outside casing 9 obtained by molding a liquid-crystal polymer (G-530, available from Nippon Petrochemicals Co., Ltd.) was bonded with an epoxy adhesive.

### Example 3

To produce a protective device according to the embodiment as shown in Figs. 3A and 3B, the procedure in Example 1 was followed except that on the low-melting metal piece 5 of the protective device a solid flux (Flux K201, available from Tarutin Co., Ltd.) was applied by means of a dispenser applicator heated to 140°C, followed by treatment in an oven with 100°C internal air circulation so as for the flux applied to uniformly spread on the low-melting metal piece 5, to form an inner sealing portion 8. The flux thus coated was in a thickness of about 0.8 mm. On the resulting inner sealing portion 8, a two-pack mixture type epoxy resin was coated so as to cover the whole surface thereof, followed by curing at 40°C for 16 hours to form an outer sealing portion 11.

### - Evaluation -

To test each of the protective devices of Examples 2 and 3, a digital multimeter was connected to the low-melting metal piece terminals 7a and 7b and a voltage of 4 V was applied across the heating element terminals 6a and 6b while watching the resistance. As a result, it was ascertained that in both the protective devices the low-melting metal pieces 5 blew in 60 seconds. Here, no low-melting metal piece was seen to flow out of the outside casing 9 or the outer sealing portion 11.

The respective protective devices were also kept in an environment of 60°C/95%RH or 105°C for 250 hours and thereafter tested by applying voltage in the same manner as the above. In this test also, the same results as in the voltage application test initially made were obtained.

As a matter of course, the present invention is by no means limited to the above Examples and can have other various embodiments so long as they do not deviate from the purport of the invention.

As described above, the protective device according to the present invention makes it possible to cause the low-melting metal piece to blow under any desired conditions when the circuit is so constructed that the current flows through the heating element of the protective device under certain conditions, and hence the protective device according to the present invention can be used as a protective device for various purposes such as voltage detection, optical detection, temperature detection and sweating detection. In particular, it can prevent overvoltage, and can be used as a protective device promising a high safety. The protective device according to the present invention also makes it possible to make chip type protective devices smaller in size while ensuring their stable operation.

## Claims

1. A protective device comprising an inorganic substrate (2), an inorganic heating element (3) provided on the substrate, an insulating layer (4) that covers the surface of the heating element, and a low-melting metal piece (5) provided on the insulating layer, wherein
said low-melting metal piece (5) is sealed by an inner sealing portion (8) having a lower melting point or lower softening point than the low-melting metal piece, and
the inner sealing portion is covered with an outside casing (9) that is provided leaving a gap between the outside casing and the inner sealing portion.

2. A protective device comprising an inorganic substrate (2), an inorganic heating element (3) provided on the substrate, an insulating layer (4) that covers the surface of the heating element, and a low-melting metal piece (5) provided on the insulating layer, wherein
said low-melting metal piece (5) is sealed by an inner sealing portion (8) having a lower melting point or lower softening point than the low-melting metal piece, and
the inner sealing portion is sealed by an outer sealing portion (11) having a higher melting point or higher softening point than the low-melting metal piece.

3. The protective device according to claim 1 or 2, wherein said insulating layer (4) is formed of an insulating resin in which an inorganic powder with a high thermal conductivity is dispersed.

4. The protective device according to claim 1 or 2, said low-melting metal piece (5) is so designed as to blow at a plurality of points as a result of heat generation of the heating element (3).

5. The protective device according to claim 1, wherein said outside casing (9) is formed of a liquid-crystal polymer or nylon 4/6.

6. An overvoltage protector comprising the protective device according to any one of claims 1 to 7 and a voltage detecting means (12),
the heating element (3) of said protective device being electrically excited to generate heat when the voltage detecting means (12) detects a voltage exceeding the rated voltage.

## Patentansprüche

1. Schutzeinrichtung mit einem anorganischen Substrat (2), einem auf dem Substrat vorgesehenen anorganischem Heizelement (3), einer isolierenden Schicht (4), welche die Oberfläche des Heizelements abdeckt, und einem niedrigschmelzenden Metallstück (5), das auf der isolierenden Schicht vorgesehen ist, wobei
das niedrigschmelzende Metallstück (5) durch einen inneren Abdichtungsabschnitt (8) abgedichtet ist, der einen niedrigeren Schmelzpunkt oder niedrigeren Erweichungspunkt als das niedrigschmelzende Metallstück hat, und der innere Abdichtungsabschnitt mit einem äußeren Gehäuse (9) abgedeckt ist, das derart geschaffen ist, daß zwischen dem äußeren Gehäuse und dem inneren Abdichtabschnitt ein Spalt gelassen wird.

2. Schutzeinrichtung mit einem anorganischen Substrat (2), einem auf dem Substrat vorgesehenen anorganischem Heizelement (3), einer isolierenden Schicht (4), welche die Oberfläche des Heizelements abdeckt, und einem niedrigschmelzenden Metallstück (5), das auf der isolierenden Schicht vorgesehen ist, wobei
das niedrigschmelzende Metallstück (5) durch einen inneren Abdichtungsabschnitt (8) abgedichtet ist, der einen niedrigeren Schmelzpunkt oder niedrigeren Erweichungspunkt als das niedrigschmelzende Metallstück hat, und der innere Abdichtungsabschnitt durch einen äußeren Abdichtungsabschnitt (11) abgedichtet ist, der einen höheren Schmelzpunkt oder höheren Erweichungspunkt als das niedrigschmelzende Metallstück hat.

3. Schutzeinrichtung gemäß Anspruch 1 oder 2, bei welcher die isolierende Schicht (4) aus einem isolierenden Harz ausgebildet ist, in welchem ein anorganisches Pulver mit einer hohen Wärmeleitfähigkeit verteilt ist.

4. Schutzeinrichtung gemäß Anspruch 1 oder 2, bei welcher das niedrigschmelzende Metallstück (5) derart gestaltet ist, daß es im Ergebnis der Wärmeerzeugung des Heizelements (3) in einer Vielzahl von Punkten durchschmilzt.

5. Schutzeinrichtung gemäß Anspruch 1, bei welcher das äußere Gehäuse (9) aus einem Flüssigkristall-Polymer oder Nylon 4/6 ausgebildet ist.

6. Überspannungsschutzeinrichtung, welche die Schutzeinrichtung gemäß einem der Ansprüche 1 bis 7 und eine Spannungserfassungseinrichtung (12) aufweist,
wobei das Heizelement (3) der Schutzeinrichtung elektrisch erregt wird, um Wärme zu erzeugen, wenn die Spannungserfassungseinrichtung (12) eine Spannung erfaßt, welche die Betriebsspannung überschreitet.

## Revendications

1. Dispositif de protection comprenant un substrat minéral (2), un élément minéral de chauffage (3) placé sur le substrat, une couche isolante (4) qui recouvre la surface de l'élément de chauffage, et une pièce (5) d'un métal à faible température de fusion placé sur la couche isolante, dans lequel
la pièce (5) de métal à faible température de fusion est enfermée de manière étanche par une partie interne d'étanchéité (8) ayant une température de fusion ou de ramollissement inférieure à celle de la pièce de métal à faible température de fusion, et
la partie interne d'étanchéité est recouverte d'un boîtier externe (9) qui est disposé afin qu'il laisse un espace entre le boîtier externe et la partie interne d'étanchéité.

2. Dispositif de protection comprenant un substrat minéral (2), un élément minéral de chauffage (3) placé sur le substrat, une couche isolante (4) qui recouvre la surface de l'élément de chauffage, et une pièce (5) d'un métal à faible température de fusion placée sur la couche isolante, dans lequel
la pièce (5) de métal à faible température de fusion est enfermée de manière étanche par une partie interne d'étanchéité (8) qui a une température de fusion ou de ramollissement inférieure à celle de la pièce de métal à faible température de fusion, et
la partie interne d'étanchéité est enfermée de manière étanche par une partie externe d'étanchéité (11) qui a une température de fusion ou de ramollissement supérieure à celle de la pièce de métal à faible température de fusion.

3. Dispositif de protection selon la revendication 1 ou 2, dans lequel la couche isolante (4) est formée d'une résine isolante dans laquelle est dispersée une poudre minérale ayant une conductibilité thermique élevée.

4. Dispositif de protection selon la revendication 1 ou 2, dans lequel la pièce (5) de métal à faible température de fusion est réalisée afin qu'elle grille en plusieurs points lors du dégagement de chaleur par l'élément de chauffage (3).

5. Dispositif de protection selon la revendication 1, dans lequel le boîtier externe (9) est formé d'un polymère à cristaux liquides ou de "Nylon" 4/6.

6. Protecteur contre les surtensions comprenant le dispositif de protection selon l'une quelconque des revendications 1 à 7 et un dispositif (12) de détection de tension,
l'élément de chauffage (3) du dispositif de protection étant excité électriquement afin qu'il dégage de la chaleur lorsque le dispositif (12) de détection de tension détecte une tension supérieure à la tension nominale.
